# EUROPEAN PATENT APPLICATION

(11) **EP 0 565 299 A1**
(43) Date of publication of application: **13.10.1993**
(21) Application number: 93302534.8
(22) Date of filing: 31.03.1993
(51) Int. Cl.: H03D 7/14

(54) **Double-balanced active mixer with single-ended-to-differential voltage-current conversion circuits**

(30) Priority: 07.04.1992 US 864987
(71) Applicant: Hughes Aircraft Company, Los Angeles, California 90080-0028 (US)
(72) Inventor: Burns, Lawrence M., El Segundo, California 90245 (US); Birdsall, Dwight D., Norwalk, California 90650 (US)
(74) Representative: Colgan, Stephen James

(57) **Abstract**

An active mixer employs a single-ended-to-differential voltage-to-current conversion circuit (Q1-Q4) to convert an input voltage signal (Vᵢₙ) to first and second pairs of complementary conversion current signals, with the two pairs of complementary current signals matched with each other. An output current steering circuit (Q11-Q14) responds to at least one of the pairs of complementary conversion current signals and to a local oscillator signal (LO, LO) to produce a pair of complementary output signals (Vₒ, V̅_{o̅}) that represent the input voltage signals modulated by the local oscillator signal. In the preferred embodiment two conversion circuits (Q1-Q4, Q1'-Q4') are used to produce the two pairs of complementary conversion current signals, which are differentially linear with respect to the input signal. The conversion current signals from one pair (14, 15) are combined with complementary conversion current signals from the other pair (16, 17) to yield a pair of complementary output signals (Vₒ, V̅_{o̅}) that are differentially linear with respect to the input signal ; each output signal by itself is single-endedly linear with respect to either the input signal or its complement.

## Description

### BACKGROUND OF THE INVENTION

### Field of the Invention

This invention relates to active mixer circuits for mixing input voltage signals with a local oscillator signal to obtain output voltage signals that can be either single-ended or differential.

### Description of the Related Art

Modern high speed signal processing systems are often limited by the relatively high distortion and low dynamic range of the mixers used in the signal conversion chain. A desire to continually expand the intermediate frequency (IF) bandwidth requires that the mixer operate at higher and higher local oscillator (LO) and radio frequency (RF) input signal frequencies.

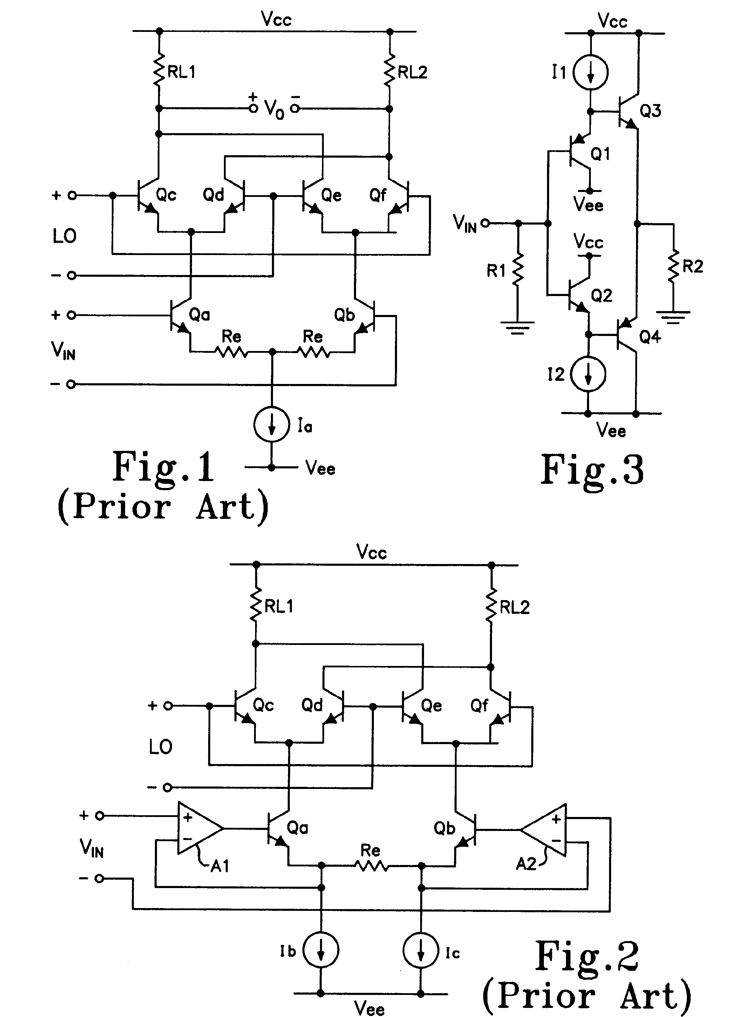

Most active mixers are implemented with a conventional Gilbert cell multiplier circuit. Such a circuit is described in Grebene, Bipolar and MOS Analog Integrated Circuit Design, John Wiley & Sons, 1984, pages 469-479, and is illustrated in FIG. 1. Differential input voltage signals Vᵢₙ are applied to the bases of a pair of differentially connected npn bipolar transistors Qa and Qb. The transistor collectors are connected to an output switching circuit that includes two differentially connected transistor pairs Qc, Qd and Qe, Qf. An LO signal is applied to the bases of Qc and Qf, while a complementary LO signal is applied to the bases of Qd and Qe. The transistors are cross-coupled, with the collectors of Qc and Qe tied together, and the collectors of Qd and Qf also tied together. The common collector connections are tied through respective load resistors RL1 and RL2 to a positive voltage bus Vcc, with an output voltage signal Vₒ taken from the mixer sides of the two resistors. Transistors Qc-Qf provide an alternating switching action that produces an output in which the polarity ofVin alternates at the LO frequency.

Acurrent is drawn through the Qa, Qb differential pair by a current source la that is connected to a voltage bus Vee at a negative voltage potential, with emitter degeneration resistors Re inserted between the emitters of Qa, Qb and the current source connection. In operation, Qa and Qb function as a voltage-to-current conversion circuit. An input voltage signal is applied to the base of Qa, while a complementary input voltage signal is applied to the base of Qb. This produces a differential amplifier action in which the current from la is steered between Qa and Qb in accordance with their respective input signals. The complementary LO signals applied to Qc and Qd cause the Qa current to flow alternately through RL1 and RL2, with the rate of alternation equal to the LO frequency. Conversely, the complementary LO signals applied to Qfand Qe cause the Qb current to flow through RL2 when the Qa current is flowing through RL1, and vice versa. A current determined by the differential value ofVin thus alternates between RL1 and RL2. The output differential voltage Vₒ is thereby modulated at the LO rate, with its magnitude and polarity tracking the input voltage signal. Single-ended outputs can also be obtained from each Vₒ terminal, but they will generally include undesirable second order harmonics.

While the Gilbert multiplier cell is generally capable of operating at high frequencies, it can suffer from poor dynamic range and high distortion for large input signals. The addition of the emitter degeneration resistors Re reduces the distortion, but also increases the circuit's noise figure and reduces its gain (in some cases causing a loss). Distortion can be reduced without increasing the noise figure by increasing the value of la, but this causes large increases in power consumption. The circuit is limited to input signals of no greater than a few hundred mV for practical values of Re, and has a limited dynamic range. While increasing the value of Re increases the maximum signal amplitude the circuit can handle, it also increases the circuit's noise figure so that the overall dynamic range remains approximately constant.

An alternate topology that is based upon a closed loop design and provides improved linearity and distortion performance, but at a cost of a very low operating frequency restriction, is shown in FIG. 2. This circuit is similar to the Gilbert multiplier cell of FIG. 1, but adds operational amplifiers A1 and A2 at the base inputs to Qa and Qb. The differential input voltage signals are applied to the positive amplifier inputs, while the emitters of Qa and Qb are tied back to the negative inputs to their respective amplifiers A1 and A2. This forces the transistor emitter voltages to equal the input voltage signals, as a result of which the transistor emitter currents are very accurate and provide high linearity and low distortion. Unfortunately, the circuit is quite slow, being limited by the bandwidth of the operational amplifiers.

### SUMMARY OF THE INVENTION

The present invention is for a high speed, low distortion, high dynamic range, double-balanced active mixer that uses complementary bipolar transistors. It utilizes a novel open loop topology that simultaneously provides low distortion, wide dynamic range, high frequency operation and a highly linear output. It has a highly symmetrical circuit topology that cancels out transfer function nonlinearities for both small and large amplitude signals, thus providing low distortion operation over a very wide dynamic range. Its open loop topology enables it to operate at very high frequencies while still maintaining low distortion.

In the preferred embodiment, a pair of single-ended-to-differential voltage-to-current conversion circuits provide two sets of differential currents that are proportional to the RF input voltage. These currents are steered through a switching circuit; the latter circuit has two sets of transistor switches that affect 0⁰ and 180° phase shifts by the action of an LO signal. Transconductance gain is set by a single resistorcon- nected between the two conversion circuits. Complementary differential output currents from the switches are then fed to a pair of grounded resistors or transim- pedance amplifiers to produce independent complementary differential output voltages; the output voltages both individually and differentially are linear with respect to the differential input voltage.

Each voltage-to-current conversion circuit preferably consists of a first pair of complementary bipolar transistors that have their bases connected to receive the differential input voltage signals, their emitters connected to respective current sources and their collectors connected to respective voltage references. A second pair of complementary bipolar transistors have their bases connected to the emitter of the like conductivity transistor in the first transistor pair, their emitters connected to a common impedance which sets the gain of the circuit, and their collectors providing respective current signals for the switching circuits. The gain setting circuit is preferably implemented as a simple resistor connected between the two voltage-to-current conversion circuits.

These and other features and advantages of the invention will be apparent to those skilled in the art from the following detailed description, taken together with the accompanying drawings.

### BRIEF DESCRIPTION OF THE DRAWINGS

FIGs. 1 and 2 are schematic diagrams of prior mixer circuits, described above;
FIG. 3 is a schematic diagram of a voltage-to-current conversion circuit employed in the preferred embodiment of the invention;
FIGs. 4 and 5 are schematic diagrams of two active mixer designs employing the invention;
FIG. 6 is a schematic diagram of a preferred embodiment of the invention;
FIG. 7 is a timing diagram that illustrates the operating sequence for the circuit of FIG. 6;
FIG. 8 is a schematic diagram of an LO driver circuit for use with mixer circuits that employ only npn transistor switches; and
FIG. 9 is a schematic diagram of an LO driver circuit for use with balanced mixer circuits that employ both npn and pnp switching transistors.

### DETAILED DESCRIPTION OF THE INVENTION

FIG. 3 shows a preferred voltage-to-current conversion circuit that is used as a "building block" for the present active mixer. This type of circuit has been used previously in connection with current mode feedback amplifiers, as discussed in Comlinear Corporation Application Notes, Application Note oA-1 0 by Steffes, "Theory and Operation of Comlinear Drive Amplifiers", 1989, pages 14-39 to 14-50. However, its use in the present mixer is unique. It provides a highly linear transconductance (voltage-to-current conversion) amplifier whose output currents are steered to perform an LO mixing function as discussed herein.

The basic conversion circuit employs bipolartran- sistors, with an input voltage signal Vᵢₙ supplied to the bases of a pair of complementary input transistors consisting of pnp transistor Q1 and npn transistor Q2; Vᵢₙ is referenced to ground through a resistor R1. The collectors of Q1 and Q2 are connected respectively to Vee and Vcc voltage reference buses, while their emitters are connected to the bases of respective npn and pnp output transistors Q3 and Q4. The collectors of Q3 and Q4 are connected respectively to Vcc and Vee, while their emitters are connected in common to ground through an output resistor R2. Current sources 11 and 12 supply bias currentfor the emitters of 01 and Q2.

The current through the output resistor R2 is the difference between the emitter currents of output transistors Q3 and Q4, which in turn is approximately equal to the difference between the Q3 and Q4 collector currents. Since input transistors Q1 and Q2 respectively match output transistors Q4 and Q3, the standing current in the input devices Q1 and Q2 also determines the standing current in the output devices Q3 and Q4. As the input voltage Vᵢₙ rises, the base voltage applied to Q3 also rises and causes the Q3 collector and emitter currents to increase. At the same time the base voltage applied to Q4 rises, causing that pnp device to reduce its current flow. Although neither the increase in the collector current of Q3 nor the decrease in collector current of Q4 is linear, the changes in the two transistors' current values are complementary so that the difference between their current values is a linear function of Vᵢₙ. Conversely, when Vᵢₙ drops the collector current of Q4 will rise and the collector current of Q3 will drop in a complementary fashion, producing a linear change in the differential between the two currents.

Q1 and Q3 in essence form an emitter follower amplifier with a unity voltage gain. The emitter voltage of 01 is one base-emitter voltage drop (about 0.7 volts) above Vᵢₙ, while the emitter voltage of Q3 is one base-emitter voltage drop below the Q1 emitter voltage. The voltage across R2 is thus equal to Vᵢₙ, Q2 and Q4 form a second emitter follower amplifier, leading to the same voltage for R2. The output differential current through R2 is thus equal to the difference between the Q3 and Q4 currents, and varies linearly with Vin.

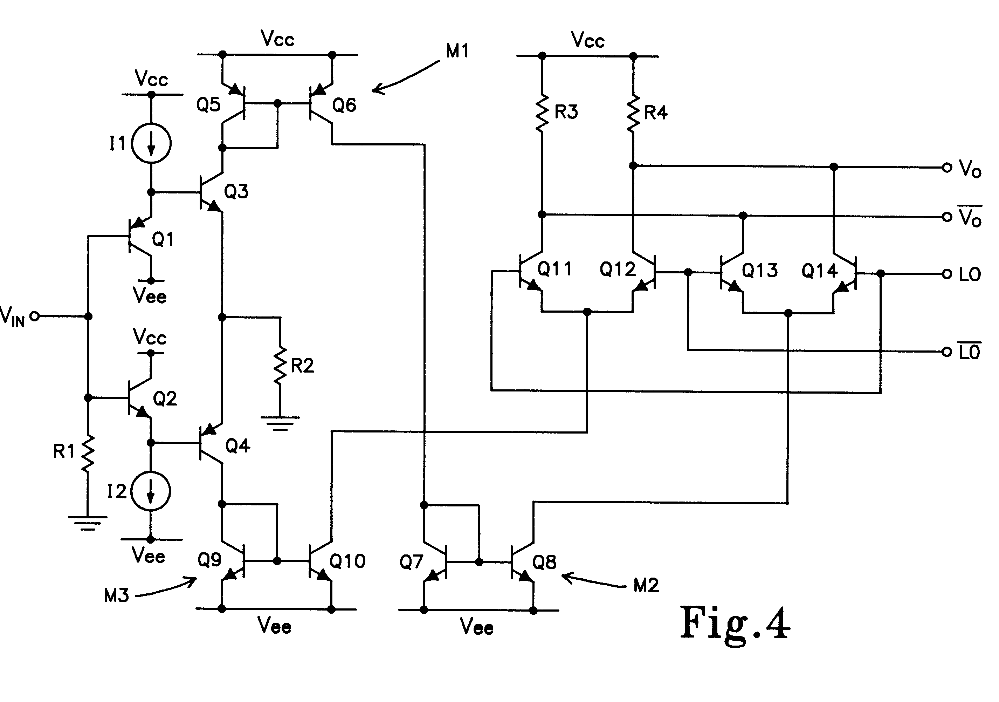

A low distortion active mixer circuit that takes advantage of the linear difference in collector currents between Q3 and Q4 in accordance with the invention is shown in FIG. 4. In this circuit the collector current of Q3 is mirrored by a pnp current mirror M1, which consists of pnp transistors Q5 and Q6. The mirrored current at the collector of Q6 is in turn mirrored by a second current mirror M2 that consists of npn transistors Q7 and Q8. Similarly, the collector current of Q4 is mirrored by an npn current mirror M3, consisting of transistors Q9 and Q10.

The output current from mirror M3 at the collector of Q10 draws current through a differential pair consisting of bipolar npn transistors Q11 and Q12, while the output current of mirror M2 at the collector of Q8 draws current from a second differential pair consisting of npn transistors Q13 and Q14; the emitters of each differential pair are connected together to their respective current mirrors. Transistors Q11 and Q12 steer their current to one of two output resistors R3 and R4, as do the transistors Q13 and Q14. A square wave LO signal is applied to the bases of Q11 and Q14, while a complenent of the LO signal is applied to the bases of Q12 and Q13. The collectors of Q12 and Q14 are connected to the output resistor R4, the other side of which is connected to the positive voltage bus Vcc, and an output voltage Vₒ is taken from the common connection of Q12, Q14 and R4. In a corresponding manner, the collectors of Q11 and Q13 are connected to the output resistor R3, the other side of which is connected to Vcc, and a complementary differential output voltage Vₒ is taken from the common connection of Q11, Q13 and R3.

The operation of the circuit can be described by first assuming that the LO signal is greater than the LO signal. Transistors Q11 and Q14 are thus turned on, while Q12 and Q13 are turned off. The mirrored collector current of Q4 thus flows through output resistor R3 via Q11, while the double-mirrored collector current of Q3 flows through output resistor R4 via Q14. It should be recalled at this point that, while neither the Q3 nor the Q4 collector currents by themselves vary linearly with Vᵢₙ, the differential between these currents does vary linearly with Vᵢₙ. Thus, since the voltages across R3 and R4 vary in proportion to the currents through them (respectively the Q4 and Q3 collector currents), the difference between the complementary differential output voltage signals Vₒ and Vₒ also varies linearly with Vᵢₙ.

During the subsequent portion of the LO cycle when LO is greater than LO, transistors Q12 and Q13 are turned on while Q11 and Q14 are turned off. This reverses the current steering action of the differential pairs, causing the twice-mirrored Q3 current to flow through R3 and the mirrored Q4 current to flow through R4. The Vₒ and V̅_{o̅} outputs thus exchange values, which in effect is a 180° phase shift compared to the output situation when LO was greater than 0. The complementary voltage outputs Vₒ and Vₒ continue to undergo successive 180° phase shifts as LO and LO continue to alternate; the result is a multiplication of the RF output signal by the square wave LO signal that achieves the desired mixing action between the two signals.

The circuit of FIG. 4 has two drawbacks. The first is that the Q3 branch is slower than the Q4 branch, both because the Q3 branch includes two current mirrors as opposed to the single mirror in the Q4 branch, and also because one of the mirrors in the Q3 branch is a pnp type that tends to be slower than npn devices. The result is unequal signal propagation delays in the two branches, which can produce distortion at high frequencies. The second drawback is that the output must be taken as a differential voltage to achieve low distortion. While the difference between the collector currents of Q3 and Q4 is highly linear, neither one alone is linear. Therefore, outputs cannot be taken single-endedly from this circuit.

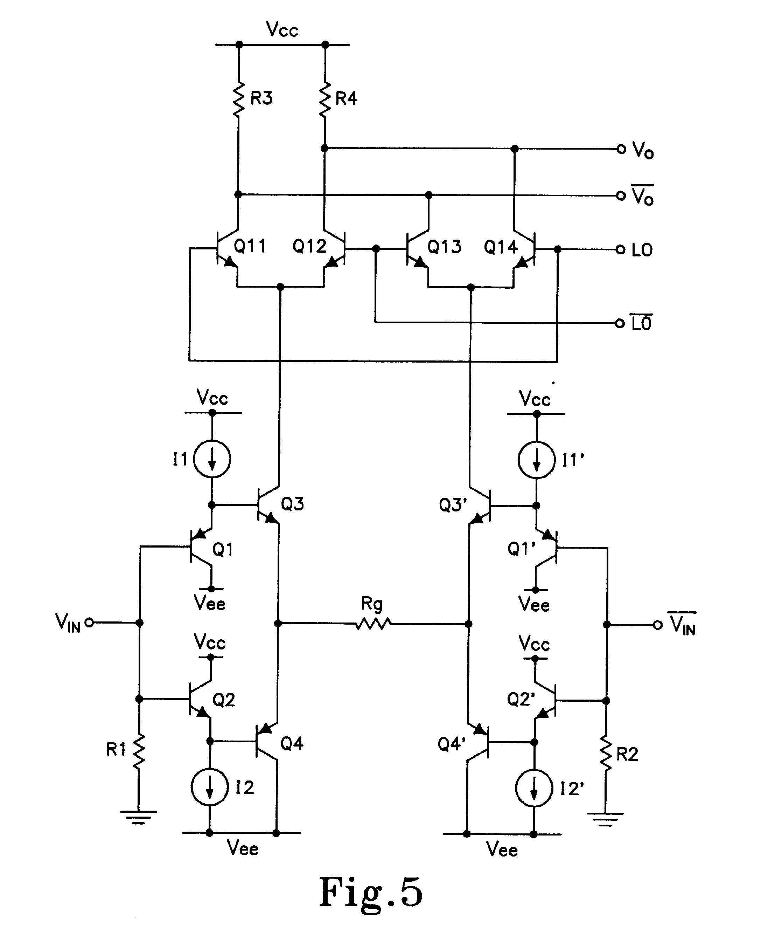

A circuit that uses the same voltage-to-current converter building block but largely eliminates the imbalance problem is shown in FIG. 5. In this circuit a pair of voltage-to-current converters are used, with the transistors of the second converter designated Q1', Q2', Q3' and Q4'. The input signal Vᵢₙ is applied to the first converter, while its complement Vᵢₙ is applied to the second converter. A gain setting impedance circuit such as resistor Rg or a series RLC circuit is connected between the common emitter connections of Q3, Q4 and Q3', Q4'. As described below, this resistor establishes the transconductance gain of the overall mixer. The same current steering circuit is used as in FIG. 4, with differential pairs Q11, Q12 and Q13, Q14, output resistors R3 and R4, complementary LO signals applied to the differential switches and complementary Vₒ signals taken from the output resistors. The collector of Q3 in the first converter circuit supplies the current for the Q11, Q12 differential pair, while the collector of Q3' in the second converter circuit provides the current for the second differential pair Q13, Q14.

In operation, assume that V̅_{i̅n̅} applied to the bases of Q1 and Q2 is greater than V̅_{i̅n̅} applied to the bases of Q1' and Q2', and that Vᵢₙ and V̅_{i̅n̅} are complementary of each other. As Vᵢₙ increases the collector current of Q3 also increases, while the collector current of Q4 decreases. In response to the complementary input voltages and with Rg as shown, the collector current of Q3' goes down while the collector current of Q4' increases in a complementary manner. This differential action causes the collector currents of Q3 and Q3' to be complements of each other, the collector currents of Q4 and Q4' to be complements of each other, and the collector currents of Q3 and Q4 to also be complements of each other. The collector current of Q3 thus equals the collector current of Q4', while the collector current of Q3' equals the collector current of Q4. If V̅_{i̅n̅} is grounded rather than set at the complement to Vᵢₙ, an increase in Vᵢₙ increases the emitter voltages of Q3 and Q4 and this is translated through Rg as an increase in the emitter voltages of Q3' and Q4'. The collector current of Q3' thus still changes in a manner complementary to the change in the Q3 collector currents, and the Q4 and Q4' collector currents are also complements of each other.

The collector currents of Q3 and Q3' are steered by their respective cross-coupled differential pairs Q11, Q12 and Q13, Q14 to produce the desired LO polarity alternation. The two currents are fed to output resistors R3 and R4, across which the output voltage is taken. The resistor Rg sets the magnitudes of the collector currents for Q3 and Q3', and thus determines the Vₒ/V_{In} voltage gain ratio. The gain is equal to R3/Rg; typical values for R3 and R4 are 50 ohms.

The principal advantage of the FIG. 5 circuit over that of FIG. 4 is that the phase shifts for each of the two output currents are now nearly equal, which considerably reduces distortion at high frequencies. Unfortunately, the voltage outputs must still be taken differentially to achieve linearity and low distortion.

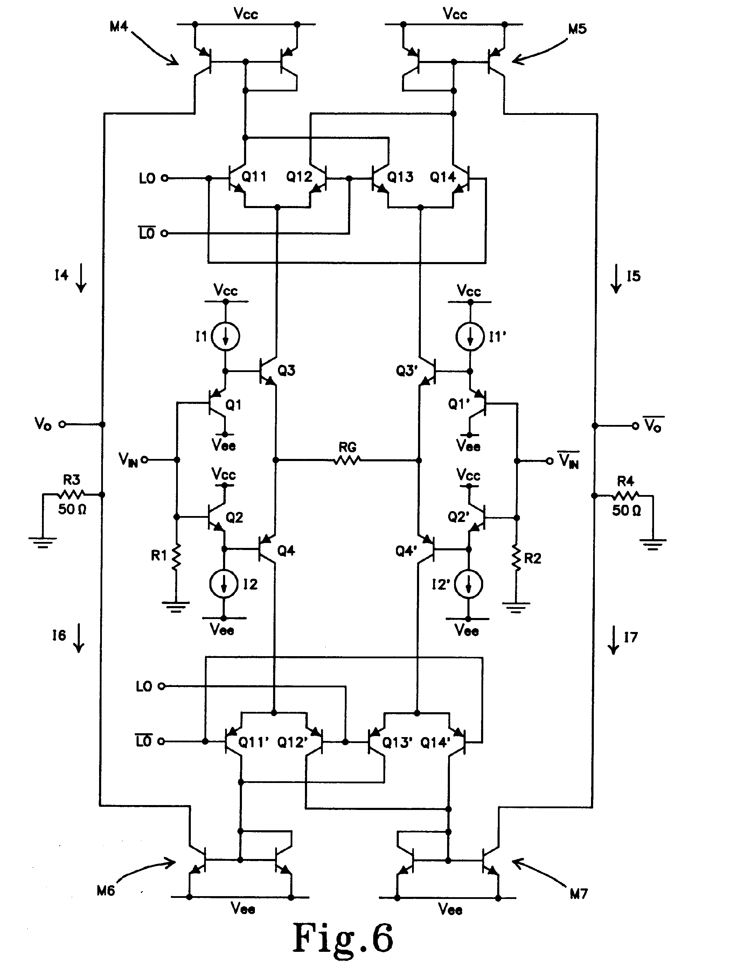

A preferred circuit that eliminates both the distortion and the single-ended output limitation of the previous two circuits is shown in FIG. 6. This circuit uses two differential voltage-to-current conversion circuits as in FIG. 5, but takes advantage of all the available converted collector currents by means of a second cross-coupled current steering circuit, consisting of transistors Q11', Q12', Q13' and Q14'. These transistors are connected in a steering design similar to Q11-Q14, but are pnp devices rather than npn; their emitters are connected to the collectors of pnp conversion output transistors Q4 and Q4', respectively. The currents from the cross-coupled transistors Q11/Q13, Q12/Q14, Q11'/Q13' and Q12'/Q14' are connected through respective current mirrors M4, M5, M6 and M7 to the output resistors, with M4 and M6 connected to R3, and M5 and M7 connected to M4. M4 and M5 have pnp transistors and are referenced to Vcc, while mirrors M6 and M7 have npn transistors and are referenced to Vee. The mirrors are necessary to produce a suitable bias scheme for the groundrefer- enced output. For example, forthe Q11-Q14 switches the LO signal will typically be a ±100mV square wave riding on a +2.5V DC level, such that the absolute value of the LO signal alternates between 2.4 and 2.6V. In this case the LO signal for the Q11'-Q14' switches would be a ±1 100mV square wave riding on a -2.5V DC level. The collectors of the npn and pnp switching transistors should thus be maintained at about +3 volts and -3 volts, respectively. Referencing these devices respectively to Vcc and Vee through the mirror circuits achieves the desired biasing.

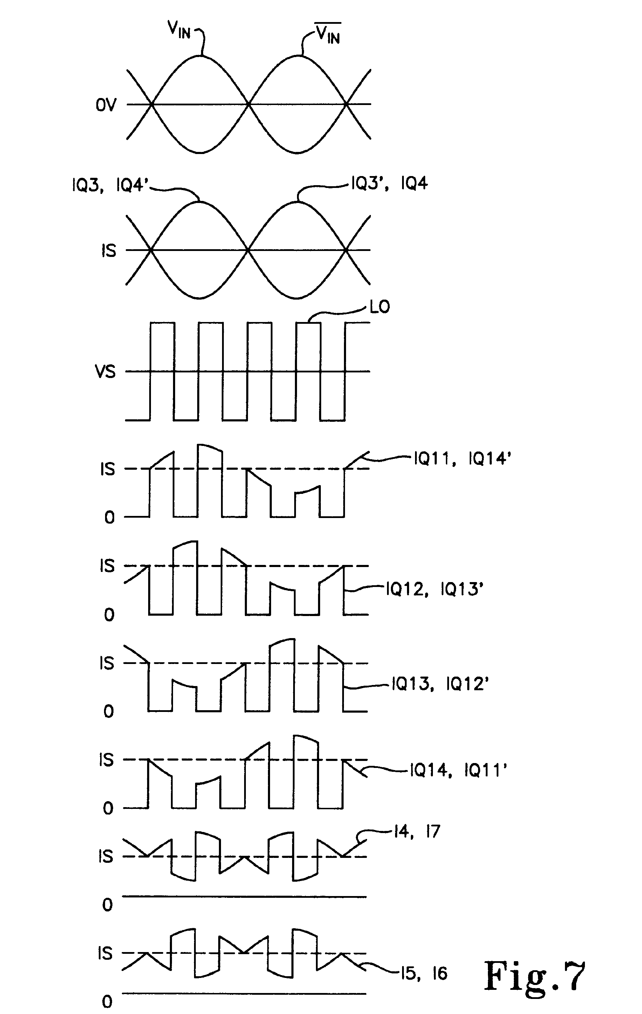

The outputs Vₒ and Vₒ from the FIG. 6 circuit are highly linear with respect to the input voltage signal, and can be taken eithersingle-endedly ordifferential- ly with very low distortion. The manner in which the circuit operates to achieve these desired results can be explained in connection with the timing diagram of FIG. 7, which illustrates the status of various circuit devices and signals over slightly more than a full cycle of the input voltage signal.

The LO and LO signals are shown in FIG. 7 as a square wave riding on a quiescent voltage VS, and having a higherfrequency than the sinusoidal Vᵢₙ and V̅_{i̅n̅} signals. The collector currents of Q3 and Q4' (IQ3 and IQ4') vary with Vᵢₙ and are shown riding on the transistor standing (quiescent) current IS, which is typically about 1mA; the peak-to-peak collector current magnitudes are typically about 0.5mA. The collector currents of Q4 and Q3'(IQ4 and IQ3') vary with Vᵢₙ. Q11 and Q14' respectively carry the IQ3 and IQ14' when the LO signal is high, Q12 and Q13' respectively carry IQ3 and IQ14' when the LO signal is high, Q13 and Q12' respectively carry IQ3' and IQ4 when the LO signal is high, and finally Q14 and Q11' respectively carry IQ3' and IQ4 when the LO signal is high. Thus, if 14, 15, 16 and 17 are designated as the currents flowing respectively between current mirrors M4, M5, M6 and M7 and the output resistors, 14 and 16 will have mutually complementary values, and 15 and 17 will also have mutually complementary values. Since 14 and 15 flow towards their respective output resistors R3 and R4, while 16 and 17 flow away from their respective output resistors R3 and R4, 16 is in effect subtracted from 14 in setting the current through R3, while 17 is subtracted from 15 in setting the current through R4. Since the difference between 14 and 16 is linear with respect to Vᵢₙ and the difference between 15 and 17 is linear with respect to Vᵢₙ, the net output voltages Vₒ and V̅_{o̅} developed across R3 and R4 are thus linear with respect to Vᵢₙ and Vᵢₙ, respectively. Furthermore, the differential between Vₒ and V̅_{o̅} in linear with respect to Vᵢₙ. Asin- gle-ended V̅_{o̅} output can thus be taken from R3, while a complementary single-ended output voltage V̅_{o̅} can be taken from R4. Alternately, since V̅_{o̅} and V̅_{o̅} are mutually complementary, a differential output voltage can be taken between these two points.

All of the outputs and inputs of FIG. 6 are referenced to ground, and thus can be easily matched to system impedance with appropriate termination resistors. The mixer is commonly used in a transmission line environment that requires proper terminations, and the FIG. 6 circuit provides for this. With typically 50 ohm transmission line inputs, the mixer can be terminated via 50 ohm ground referenced resistors. Since R1 and R2 are referenced to ground, no input DC blocking capacitor is required. The outputs are taken from the collectors of the switching transistors Q11-Q14 and Q11'-Q14', which have high output impedances providing a good match when terminated ground referenced resistors are used; the output resistors R3 and R4 are also ground referenced.

The maximum input signal applied to the Gilbert multiplier cell shown in FIG. 1 is typically limited to a few hundred mV. In the FIG. 6 circuit, by contrast, an input voltage limit is reached only when the voltages at the collectors of Q3, Q4, Q3' and Q4' approach the voltages at the emitters of Q11-Q14 and Q11'-Q14'. With an LO DC bias level of typically ±2.5 volts for ±5 volt operation and a base-emitter voltage drop of about 0.7 volts for the switching transistors, the circuit's input range is about ±1.8 volts. Simulations show an expected third-order intercept point in excess of +40 dBm at 100 MHz using a 5 GHz complementary bipolar process.

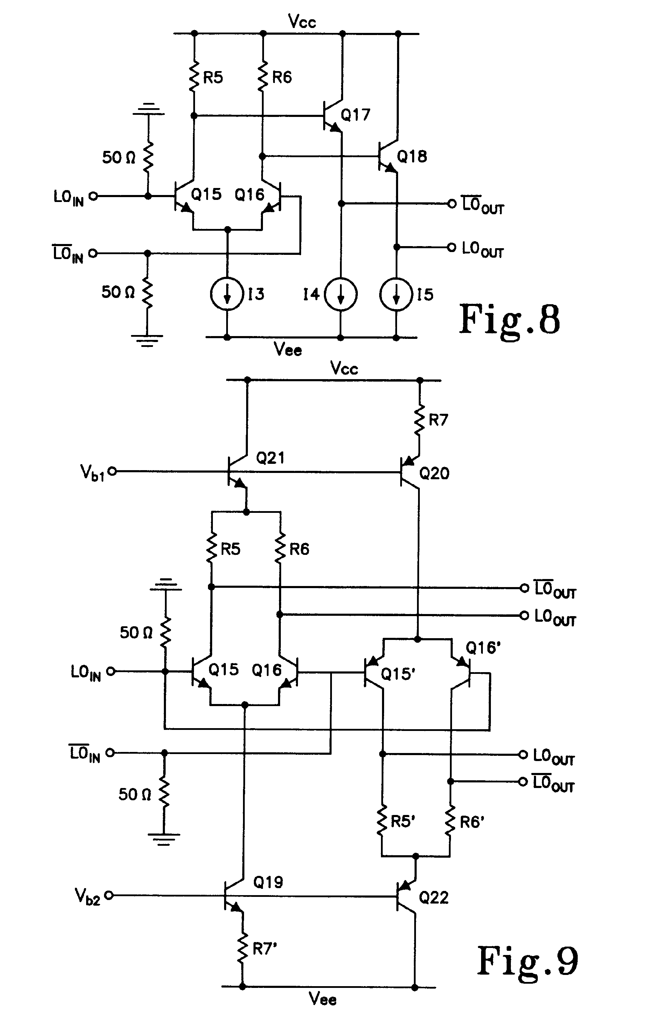

The schematics of FIGs. 8 and 9 show two possible LO driver circuits that can be used to provide the differential LO and LO signals from a single-ended or differential input to the current steering switches. The circuit shown in FIG. 8 is used when the current switching steering circuit employs only npn switching transistors, as in FIGs. 4 and 5, while the circuit shown in FIG. 9 is used when both npn and pnp switching transistors are used as in FIG. 6. The driver circuits provide fast rise/fall time output square wave signals LOₒᵤₜand LOₒᵤₜ to the mixer in response to low level, sinusoidal LO input signals LOin and LOin; this is necessary to achieve low distortion and high frequency conversion gain.

In the FIG. 8 circuit, complementary LO input signals are fed to the bases of an npn differential transistor pair Q15, Q16, with current source 13 drawing current through the pair. The currents through Q15 and Q16 flow through output resistors R5 and R6, respectively, to establish respective bias voltages for output npn transistors Q17 and Q18, with current sources 14 and 15 drawing currents through these latter devices. Complementary differential square wave LO outputs are taken from emitters of Q17 and Q18.

The driver circuit of FIG. 9 provides a second differential pair Q15' and Q16' to which the LO input signals are applied as well as to Q15 and Q16. The Q15', Q16' differential pair includes output resistors R5' and R6' in their respective collector circuits. Current source transistors Q19 and Q20 are biased respectively by bias lines Vb1 and Vb2 to provide currents for the Q15/Q16 and Q15'/Q16' differential pairs, respectively. Cascoded transistors Q21 and Q22 are biased respectively by Vb1 and Vb2 on the opposite sides of the output resistors for Q15/Q16 and Q15'/Q16', respectively, and provide DC bias levels. One pair of complementary LO outputs is taken from the collectors of Q15 and Q16, while a second set of complementary LO outputs is taken from the collectors of Q15' and Q16'.

The complementary LO outputs from npn devices Q15 and Q16 of FIG. 9 are provided to the pnp switch transistors Q11'-Q14' of FIG. 6, while the complementary LO outputs from pnp devices Q15' and Q16' are provided to the npn switch transistors Q11-Q14. The circuitry associated with each set of switches in FIG. 6 thus includes one set of npn and one set of pnp transistors. This provides a phase matched switching operation that compensates for the pnp transistors usually being blower than the npn devices. Furthermore, the sinusoidal LO input signal to the driver circuit drives a high impedance input that can be terminated to ground through a resistor to make all inputs and outputs, including the LO signal, ground referenced and well matched.

While several embodiments of a high speed, low distortion, high dynamic range, balanced and linear active mixer have been shown and described, numerous variations and alternate embodiments will occur to those skilled in the art. Accordingly, it is intended that the invention be limited only in terms of the appended claims.

## Claims

1. An active mixer circuit, comprising:
a pair of single-ended-to-differential voltage-to-current conversion circuits for converting a input voltage signal to first and second pairs of complementary conversion current signals, with the first pair of conversion current signals matched with the second pair of conversion current signals, and
output current steering means responsive to at least one of said pairs of conversion current signals and to a local oscillator signal for producing a pair of complementary output signals that represent said input voltage signal modulated by said local oscillator signal.

2. The active mixer circuit of claim 1, each of said conversion circuits comprising a first pair of complementary bipolar transistors having their bases connected to receive respective ones of said input voltage signals, their emitters connected to respective current sources and their collectors connected to respective voltage references, and a second pair of complementary bipolar transistors having their bases connected to the emitter of the like conductivity transistor in said first transistor pair, their emitters connected to a gain setting circuit, and their collectors providing one of the current signals for each of said first and second pairs of complementary conversion current signals.

3. The active mixer circuit of claim 2, said gain setting circuit comprising an impedance connected between the emitter of the second pairs of transistors for said pair of conversion circuits.

4. The active mixer circuit of claim 1, said output current steering means comprising a first current steering circuit that is responsive to one of said pairs of complementary conversion current signals and to a pair of complementary local oscillator signals to produce a first pair of complementary output current signals that differentially represent said input voltage signals modulated by said local oscillator signal, a second current steering circuit that is responsive to the other of said pairs of complementary conversion current signals and to said pair of complementary local oscillator signals to produce a second pair of complementary output current signals that respectively match said first pair of complementary output current signals, first output means for differentially combining an output current signal from said first current steering circuit with a complementary output current signal from said second current steering circuit to produce a first net output signal that alternates at the local oscillator rate and varies substantially linearly with said input voltage signal, and second output means for differentially combining the other output current signals from said first and second current steering circuits to produce a second net output signal that is complementary to said first net output signal.

5. An active mixer circuit, comprising:
means for converting an input voltage signal to first and second pairs of conversion current signals, with the currents of each pair complementary to each other and matched with respective currents of the other pair, and
current steering means for mixing at least one conversion current signal from each of said pairs with a mixing signal to produce an output voltage signal that varies substantially linearly with said input voltage signal.

6. The active mixer circuit of claim 5, said converting means comprising at least one conversion circuit with a first pair of complementary bipolar transistors having their bases connected to receive said input voltage signal, their emitters connected to respective current sources and their collectors connected to respective voltage references, and a second pair of complementary bipolar transistors having their bases connected to the emitter of the like conductivity transistor in said first pair, their emitters connected to a gain setting circuit, and their collectors providing at least one of the current signals for each of said pairs of complementary conversion currents.

7. The active mixer circuit of claim 6, said converting means comprising a matched pair of said conversion circuits for receiving said input voltage signal in the form of complementary input voltage signals applied to respective ones of said conversion circuits.

8. The active mixer circuit of claim 7, the emitters of the second pairs of complementary bipolar transistors for said pair of conversion circuits being connected to respective opposite sides of a common gain setting circuit.

9. The active mixer circuit of claim 7, wherein the collectors of like conductivity transistors in said second pairs of complementary bipolar transistors provide one of said pairs of complementary conversion currents, and the collectors of the other transistors in said second pairs of complementary bipolar transistors provide the other of said pairs of complementary conversion currents.

10. The active mixer circuit of claim 6, said converting means comprising a single one of said converting circuits, the collectors of said second pair of complementary bipolar transistors in said converting circuit providing one current for each of said pairs of complementary currents, and further comprising current mirror means mirroring the currents in the collectors of said second pair of complementary bipolar transistors to provide the other current for each of said pairs of complementary currents.

11. The active mixer circuit of claim 5, said current steering means comprising two differentially connected and cross-coupled bipolar transistor pairs with the emitters of each differential pair connected in common to receive respective complementary current signals from said input voltage converting means, their bases connected to receive complementary mixing signals, and their collectors connected to respective voltage output circuits for producing a pair of complementary output voltage signals in response to said complementary current signals.

12. The active mixer circuit of claim 11, said converting means comprising a matched pair of said conversion circuits for receiving respective complementary differential input voltage signals, one of said output differential pairs being connected to receive current from one of said conversion circuits and the other of said output differential pairs being connected to receive a complementary current from the other of said conversion circuits.

13. The active mixer circuit of claim 11, wherein said complementary mixing signals comprise a local oscillator signal and its complement.

14. An active mixer circuit, comprising:
means for converting an input voltage signal to first and second pairs of complementary conversion current signals,
first and second current steering means for mixing respective ones of said first and second pairs of complementary conversion current signals with a mixing signal to produce respective pairs of complementary output current signals, and
means for differentially combining one of the output current signals from one of said pairs of complementary output current signals with a complementary output current signal from the other of said pairs to obtain a first net output signal that is substantially linear with respect to said input voltage signal.

15. The active mixer circuit of claim 14, further comprising means for differentially combining the other of said output current signals from said one pair of complementary output current signals with a complementary output current signal from said other pair to obtain a second net output signal that is substantially complementary to said first output signal.

16. The active mixer circuit of claim 14, further comprising an impedance in circuit with said differentially combined output current signals to produce an output voltage signal that is substantially linear with respect to said input voltage signal.

17. The active mixer of claim 14, wherein said converting means converts said input voltage to first and second pairs of conversion current signals, with the currents of each pair complementary to each other and substantially matched with respective currents of the other pair.

18. The active mixer circuit of claim 14, said converting means comprising a matched pair of conversion circuits for receiving respective complementary input voltage signals, each of said conversion circuits comprising:
a first pair of complementary bipolar transistors having their bases connected to receive the input voltage signal for the conversion circuit, their emitters connected to respective current sources and their collectors connected to respective voltage references, and
a second pair of complementary bipolar transistors having their bases connected to the emitter of the like conductivity transistor in said first pair, their emitters connected to a gain setting circuit, one of their collectors providing one of the current signals for said first pair of complementary conversion current signals, and the other of their collectors providing one of the current signals for said second pair of complementary conversion current signals.

19. The active mixer of claim 18, said first and second current steering means each comprising respective first, second, third and fourth bipolar transistors of like conductivity, the emitters of the first and second transistors connected together to receive a conversion current from one of said conversion circuits and the emitters of the third and fourth transistors connected together to receive a complementary conversion current from the other of said conversion circuits, the bases of said first and fourth transistors connected to receive a first mixing signal and the bases of said second and third transistors connected to receive a second mixing signal that is complementary to the first mixing signal, the collectors of said first and third transistors corrected together to produce a first output current signal and the collectors of said second and fourth transistors connected together to produce a second output current signal that is complementary to said first output current signal.

20. The active mixer of claim 19, said combining means comprising means for mirroring each of said output current signals, means for differentially combining a first pair of complementary mirrored currents from said first and second current steering means into said first net output signal, and means for differentially combining a second pair of complementary mirrored currents from said first and second current steering means into a second net output signal that is complementary to said first net output signal.

21. The active mixer of claim 19, wherein the transistors of said first current steering means are of like conductivity to, and are connected to receive conversion currents from, one of the second transistors of each conversion circuit, and the transistors of said second current steering means are of unlike conductivity to the transistors of said first current steering means but are of like conductivity to, and are connected to receive conversion currents from, the other of the second transistors of each conversion circuit.

22. The active mixer of claim 21, further comprising a drive circuit for providing local oscillator mixing signals to said first and second current steering means, said drive circuit including bipolar transistors that are complementary to the transistors of said first current steering means for providing mixing signals thereto, and bipolar transistors that are complementary to the transistors of said second current steering means for providing mixing signals thereto, thereby enabling phase matched switching by the transistors of said first and second current steering means.

23. The active mixer of claim 14, said converting means comprising a matched pair of conversion circuits for receiving respective complementary input voltage signals, said first and second current steering means each comprising respective first, second, third and fourth bipolar transistors of like conductivity, the emitters of the first and second transistors connected together to receive a conversion current from one of said conversion circuits and the emitters of the third and fourth transistors connected together to receive a complementary conversion current from the other of said conversion circuits, the bases of said first and fourth transistors connected to receive a first mixing signal and the bases of said second and third transistors connected to receive a second mixing signal that is complementary to said first mixing signal, the collectors of said first and third transistors connected together to produce a first output current signal and the collectors of said second and fourth transistors connected together to produce a second output current signal that is complementary to said first output current signal.

24. The active mixer of claim 23, said combining means comprising means for mirroring each of said output current signals, means for differentially combining a first pair of complementary mirrored currents from said first and second current steering means into said first net output signal, and means for differentially combining a second pair of complementary mirrored currents from said first and second current steering means into a second net output signal that is complementary to said first net output signal.

25. The active mixer of claim 23, wherein the transistors of said first current steering means are of like conductivity to each other and are of opposite conductivity to the transistors of said second current steering means.
